# EUROPEAN PATENT APPLICATION

(11) **EP 3 971 973 A1**
(43) Date of publication of application: **23.03.2022**
(21) Application number: 20196866.6
(22) Date of filing: 18.09.2020
(51) Int. Cl.: H01L 27/095, H01L 29/423, H01L 29/778, H01L 29/812, H01L 21/8238, H01L 27/06, H01L 27/092, H01L 21/8252, H01L 27/088

(54) **INVERTERS, AMPLIFIERS AND UNIVERSAL GATES BASED ON STACKED GATE MESFET AND HEMT**

(71) Applicant: III-V Technologies GmbH, Wien (AT)
(72) Inventor: Raissi, Farshid, 1010 WIEN (AT)
(74) Representative: Glawe, Delfs, Moll

(57) **Abstract**

Combination of an n type and p type normally OFF stacked-gate MESFETs to create an inverter amplifier, which is also used as a NOT digital gate, wherein a source of the n type device is connected to the low voltage and that of the p type to the high voltage, wherein a drain of the n type and source of the p type are connected together and constitute the output, wherein gates of the two devices are connected and constitute the input.

## Description

This invention relates to using stacked gate MESFETs to provide universal digital gate systems. For elemental semiconductors such as Si or 2-dimensional materials for which acceptable p-channel devices can be obtained a combination of an n and p-channel stacked MESFETs is proposed as the standard NOT gate. In this case both devices must be either normally OFF or normally ON for proper operation. This complementary MESFET (CMES) structure is proposed as an alternative to complementary MOS (CMOS) devises. For other semiconductors such as GaAs and GaN where p-channel devices are not normally used, and they are used as HEMT transistors, a combination of a normally OFF and a normally ON source-connected n-channel HEMT is proposed as the NOT gate. Obtaining NAND, NOR, and XOR gates from this NOT gate are identical to the CMOS circuit designs and are well known to the experts in the field. MEFETS provide low noise operation and can operate at lower voltages than CMOS circuits. Other advantages include easier and cheaper fabrication processes and higher operational speed.

According to the invention a combination of an n type and p type normally OFF stacked-gate MESFETs is provided to create an inverter amplifier, which is also used as a NOT digital gate. A source of the n type device is connected to the low voltage and that of the p type to the high voltage. A drain of the n type and source of the p type are connected together and constitute the output. Gates of the two devices are connected and constitute the input. Normally OFF devices are either obtained by proper use of the first gate metal layer with a work function that extends the depletion region all the way through the semiconductor or by applying a bias voltage to it for the same purpose.

The invention also relates to a combination of an n type and p type normally ON stacked-gate MESFETs is provided to create an inverter amplifier, which is also used as a NOT digital gate. A source of the n type device is connected to the low voltage and that of the p type to the high voltage. A drain of the n type and source of the p type are connected together and constitute the output. Gates of the two devices are connected and constitute the input.

In a preferred embodiment added transistors in series or in parallel combination of one or both transistors are used to create multi input and other digital gates such as NAND, NOR, XOR, etc.

The inventive circuits can be used in any amplifying circuit such as input or output of operational amplifiers, current mirrors, current sinks or sources and basically all possible circuits whose basis of operation is relying on the stacked-gate with its normally OFF or normally ON characteristics.

The invention further relates to a combination of two n type stacked-gate MESFETs or HEMTs for non-elemental semiconductors that don't use p type devices, to create an inverter amplifier, which is also used as a NOT digital gate. One is normally OFF and its source is connected to the low voltage. The other is normally ON and its source is connected to the drain of the first transistor. Its gate and source are also connected to each other to provide a dynamic resistor. The drain of this transistor is connected to high voltage. This claim also covers two p type stacked-gate MESFETS connected the same way for particular situations and applications.

Added transistors in series or parallel combination of one or both transistors can be used to create multi input and the rest of the digital gates such as NAND, NOR, XOR, etc.

The circuit of claim can be used in any amplifying circuits such as input or output of operational amplifiers, current mirrors, current sinks or sources and basically all possible circuits whose basis of operation is relying on the stacked-gate with its normally OFF or normally ON characteristics.

The gate of the normally ON transistor can be connected to a certain biasing voltage, or the use of any type of transistor to create an active resistor in place of this transistor or the use of passive resistors.

Various doping profiles in the semiconductor material of the circuits can be used to achieve very large Ion/Ioff ratios with small gate voltage; hence achieving very low power circuits.

MESFET transistors inherently provide lower noise than regular MOSFET transistors and can operate at much lower power levels. In general they can operate at higher frequencies because of larger mobility of carriers and less parasitic capacitors. They fall under the category of junction field effect transistors and because their operation is hampered by lack of a viable normally OFF transistor and also because only one voltage polarity is allowed for proper operation, obtaining universal gates for digital operations has proven challenging.
In these devices only one voltage polarity is allowed because the Schottky contact must remain reverse biased at all times. In this invention we use stacked gate MESFETs to propose viable universal digital gates. Two properties of the stacked MESFETs make this possible. First, it is possible to forward bias the stacked MESFETs without fear of electrical current passing from the gate into the semiconductor. Second, the forward bias voltage decreases the Schottky depletion region and gives us the opportunity to devise normally OFF transistors quite readily. Operations of the proposed digital gates rely on the behavior of these normally OFF and forward biased Schottky junctions.

In the following, the invention is described in exemplary fashion on the basis of advantageous embodiments, with reference being made to the attached drawings. In detail:

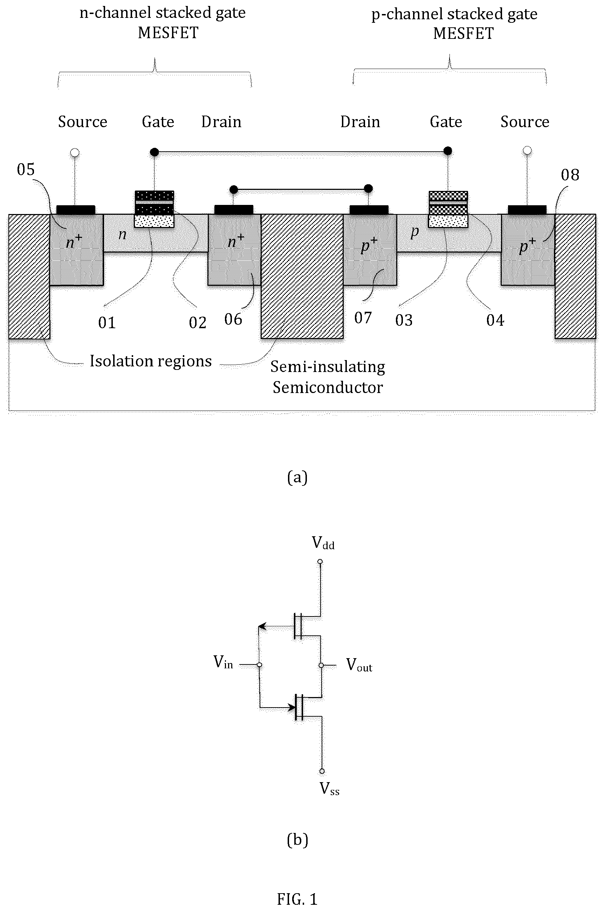

FIG. 1.a. shows the configuration for the proposed CMES universal NOT gate using complementary n and p channel transistors.
FIG. 1. b. A circuit representation of the circuit of FIG.1. a.
FIG. 2. a shows a second configuration for the CMES universal NOT gate based on normally OFF n and p type transistors.

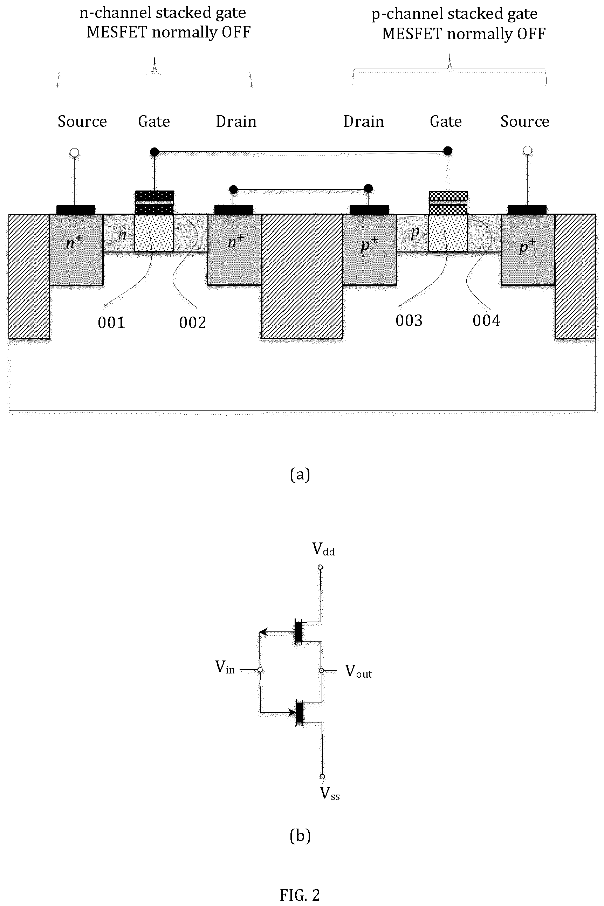

Fig. 2. b. A circuit representation of the circuit of FIG.2. a.

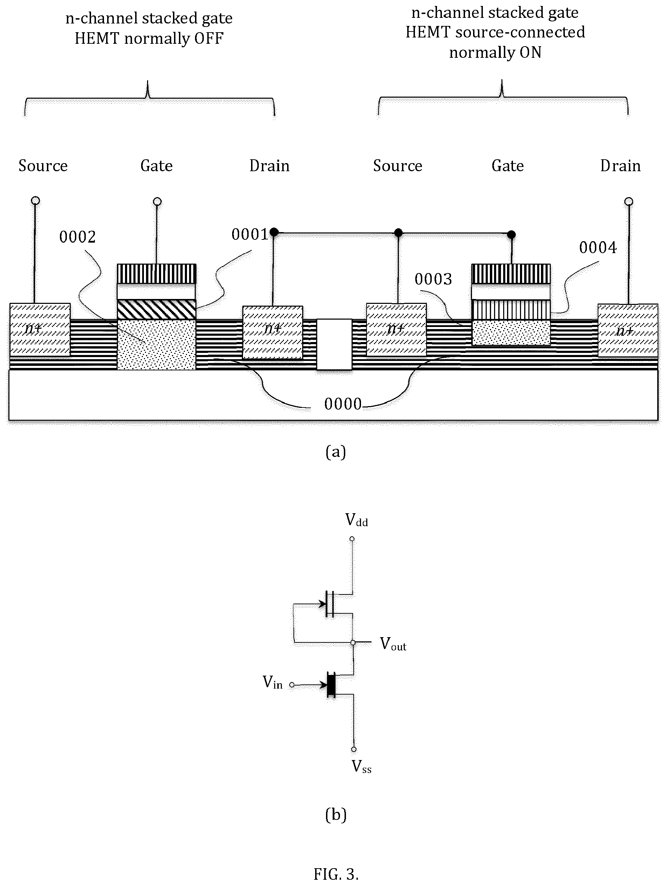

FIG. 3. a shows the NOT configuration for non-elemental semiconductors such as GaAs and GaN, which do not have viable p channel devices and are normally fabricated as HEMT transistors.
Fig. 3. b. A circuit representation of the circuit of FIG.3. a.

FIG. 1.a. shows the configuration for the proposed CMES universal NOT gate using complementary n and p channel transistors. Over a semi-insulating semiconductor n and p regions are created over which stacked gates are deposited. The semiconductor could also be 2D semiconductor material. The bottom metal gate's 02 and 04 create Schottky contacts to these n or p type regions with corresponding depletion regions 01 and 03. 05 and 06 denote the source and drain of the left transistor, respectively, and 07 and 08 denote drain and sources of the right hand side transistor, respectively. The gates of the two transistors are connected and constitute the input and drains of the two transistors 06 and 07 are also connected and constitute the output of the NOT gate. The circuit representation is provided in FIG. 1. b. Arrow pointing toward the gate connection represents n type device and the opposite represents p type device. Vₛₛ and V_{dd} connections are shown as well as the input and output connections.

FIG. 2. a shows a second configuration for the CMES universal NOT gate based on normally OFF n and p type transistors. Everything is the same as FIG.1. a except the metals 002 and 004 are such chosen that depletion regions 001 and 003 penetrate all the way into the semiconductor and impede current movement when no voltage is applied to the gates. The circuit representation is provided in FIG.2. b in which the normally OFF transistor, or also known as depletion transistor, is designated by the blackened area as opposed to normally ON devices of FIG.1. a. Normally off devices are either obtained by changing the work function of the bottom gate metal layer or by applying a bias voltage to it to extend the depletion region all the way through the semiconductor.

FIG. 3. a shows the NOT configuration for non-elemental semiconductors such as GaAs and GaN, which do not have viable p channel devices and are normally fabricated as HEMT transistors. It also covers 2D material that might not have acceptable p type or n type versions. The HEMT region is designated by 0000 and sits on top of an insulating or semi-insulating layer. Metal layer 0001 is chosen such that its work function creates a depletion region 0002 that extends all the way through the semiconductor at equilibrium. The depletion layer 0003 of the right hand side transistor does not extend all the way through the semiconductor due to the work function of the metal layer 0004. The source and gate of the right hand side transistor are connected together to provide a non-linear resistor. The two transistors are isolated at the middle by an insulating barrier. Input is applied to the gate of the left transistor. Output is obtained from the drain of the left transistor, which is also connected to the source and the gate of the right transistor. Circuit representation and connections between the two transistors and input and output are provided in FIG. 3. b. for clarity. Normally off devices are either obtained by changing the work function of the bottom gate metal layer or by applying a bias voltage to it to extend the depletion region all the way through the semiconductor.

Looking at FIG. 1. a and b the source of the right p-type device is connected to the high voltage V_{dd} and the source of the left n-type device is connected to the low voltage Vₛₛ. The gates of these two devices are connected and represent the input.

The drains of these two devices are also connected and represent the output. The NOT operation is as follows.
If a low voltage is applied to the gates, the left n channel transistor is reverse biased and its depletion region extends all the way through the semiconductor and turns it off. On the other hand the right p channel transistor has its depletion region reduced because it is forward biased and the device is ON. As a result V_{dd} is connected to the output and the output would be high.
If on the other hand a high voltage is applied to the gates, the left transistor is ON because it is forward biased and its depletion region shrinks and the right turns off because it is reverse biased and its depletion region extends all the way. As a result the output would be connected to Vₛₛ amounting to the low voltage.
This NOT gate may not present an optimum amplifying device when used as an inverter amplifier because both transistors are ON when the input voltage is between V_{dd} and Vₛₛ. It is more appropriate in some applications for these transistors to be OFF at such input voltages. For such cases the circuit of FIG. 2 is suggested.

The NOT operation of FIG. 2, which is similar to CMOS inverter operation (CMOS, the ideal logic family, Fairchild Semiconductor; Application Note 77, Jan 1983.) is as follows. Imagine input is at its low or Vₛₛ level. In other words the source and the gate of the left transistor are at the same level. This means its depletion region extends all the way down and prevents electrons from flowing through the semiconductor from source to drain. On the other hand the p type device has its gate voltage lower than its source and being p type is forward biased and as a result the depletion region contracts and the device turns ON and provides a path for current flow from drain to its source or from V_{dd} to output. As a result output voltage equals V_{dd} or it turns high.
On the other hand a high input level does the opposite to the two devices, meaning the n device turns ON and the p device turns OFF and the output turns low. This constitutes the NOT operation of this novel configuration. This circuit also represents an inverter amplifier, which has applications in various amplifying circuits including and not limited to operational amplifiers and analogue to digital and digital to analogue converters. One advantage of using this CMES design over CMOS inverter is that it does not need a minimum threshold voltage on its gate to turn on. As a result it can operate at much lower voltage and power levels.
It should be understood that the structural realizations given in FIG.1. a and 2. a are presented as one possible realization of the concept and any change in the shape of various regions shown in the figure does not constitute a novel change to the concept of this invention, neither does increasing the number of transistors in a cascade configuration. It is clear to the experts in the field that various device structures could be envisioned that could use the stacked-gate idea to achieve the same results but do not constitute an original idea. It is also possible to connect the bottom metal gate to the source of the device and obtain new IV characteristics while obtaining the NOT operation but this does not constitute a new circuit.

The circuit in FIG. 3 uses only n type transistors and is useful when dealing with compound semiconductors such as GaAs and GaN, etc. which do not provide high mobility holes. In such cases high frequency circuits are only made using n channel devices. In FIG. 3 the left transistor is normally OFF and the right transistor or the load transistor is normally ON. The work functions of the bottom metal gate for each transistor, which controls the size or the thickness of the depletion region determines whether each transistor is normally OFF or ON. Or this layer can be biased with a voltage to obtain an OFF device. The gate and source of the normally ON transistor, which is called load transistor, are connected to each other. This creates a voltage-controlled resistor or a nonlinear resistor, from the source to the drain. As seen the source of the normally OFF transistor is connected to the low voltage Vₛₛ and the drain of the load transistor is connected to high voltage V_{dd}. The drain of the normally OFF transistor and the source of the load transistor are connected and represent the output terminal. Connection to the gate of the normally OFF transistor represents the input terminal. If a high voltage is applied to the this transistor the Schottky junction between the bottom metal and semiconductor becomes forward biased and the depletion region depth decreases and the transistor turns ON and connects Vₛₛ to the output. Since the output is connected to the gate of the load transistor, the depth of the depletion region at the source side does not change. The right hand side, however, expands because the gate has a lower voltage compared to the drain and the junction has become reverse biased. This means that the load transistor is representing a large resistor. Since the transistor to the left in FIG 3.a or at bottom in FIG.3.b has turned ON it represents a low resistance. As a result the voltage at the output would be very close to Vₛₛ or low voltage by about the same ratio of the two resistors. This results in a low voltage and means that a high input had provided a low output.
On the other hand if a low voltage is applied to the input, the left transistor remains off and represents an open circuit. The right transistor is ON because its source and gate are connected. As a result the drain voltage or V_{dd} is transferred to the source and to the output. Therefore, the low input level has resulted in a high output. This constitutes operation of this circuit as an inverter amplifier and as a digital NOT gate.
It should be understood that the configuration of FIG. 3. a is presented as one possible realization of the concept and any change in the shape of various regions shown in the figure does not constitute a novel change to the concept of this invention, neither does increasing the number of transistors in a cascade configuration. It is clear to the experts in the field that various device structures could be envisioned that could use the stacked-gate idea to achieve the same results but do not constitute an original idea.

## Claims

1. Combination of an n type and p type normally OFF stacked-gate MESFETs to create an inverter amplifier, which is also used as a NOT digital gate, wherein a source of the n type device is connected to the low voltage and that of the p type to the high voltage, wherein a drain of the n type and source of the p type are connected together and constitute the output, wherein gates of the two devices are connected and constitute the input, and wherein a normally OFF device is obtained either by proper use of the first gate metal layer with a work function that extends the depletion region all the way through the semiconductor or by applying a bias voltage to it for the same purpose.

2. Combination of an n type and p type normally ON stacked-gate MESFETs to create an inverter amplifier, which is also used as a NOT digital gate, wherein a source of the n type device is connected to the low voltage and that of the p type to the high voltage, wherein a drain of the n type and source of the p type are connected together and constitute the output, and wherein gates of the two devices are connected and constitute the input.

3. Circuits of claims 1 and 2 with added transistors in series or parallel combination of one or both transistors to create multi input and other digital gates such as NAND, NOR, XOR, etc.

4. Circuits of claim 1 and 2 used in any amplifying circuit such as input or output of operational amplifiers, current mirrors, current sinks or sources.

5. Combination of two n type stacked-gate MESFETs or HEMTs for non-elemental semiconductors that don't use p type devices, to create an inverter amplifier, which is also used as a NOT digital gate, wherein one is normally OFF and its source is connected to the low voltage, wherein the other is normally ON and its source is connected to the drain of the first transistor, wherein its gate and source are also connected to each other to provide a dynamic resistor, wherein the drain of the transistor is connected to high voltage.

6. Circuit of claim 5 with added transistors in series or parallel combination of one or both transistors to create multi input and the rest of the digital gates such as NAND, NOR, XOR, etc.

7. Circuit of claim 5 used in any amplifying circuits such as input or output of operational amplifiers, current mirrors, current sinks or sources.

8. Circuit of claim 5 with the gate of the normally ON transistor connected to a certain biasing voltage, or the use of any type of transistor to create an active resistor in place of this transistor or the use of passive resistors.

9. Using various doping profiles in the semiconductor material of circuits of claims 1 and 5 to achieve very large Ion/Ioff ratios with small gate voltage; hence achieving very low power circuits.
